# EUROPEAN PATENT SPECIFICATION

(11) **EP 0 622 900 B1**
(45) Date of publication and mention of the grant of the patent: **02.04.2003**
(21) Application number: 94106696.1
(22) Date of filing: 28.04.1994
(51) Int. Cl.: H03J 1/00, H04B 1/20

(54) **Data transmission method of a remote controller**
Verfahren zur Datenübertragung einer Fernsteuerung
Système de transmission de données pour une commande à distance

(30) Priority: 28.04.1993 KR 9307191
(43) Date of publication of application: 02.11.1994
(73) Proprietor: SAMSUNG ELECTRONICS CO., LTD., Suwon-City, Kyungki-do (KR)
(72) Inventor: Shim, Soon Sun, Suwon-city, Kyungki-do (KR)
(74) Representative: Grünecker, Kinkeldey, Stockmair & Schwanhäusser Anwaltssozietät

(56) References cited:
- EP-A- 0 392 872
- US-A- 4 866 434

## Description

The present invention relates to a data transmission method for a remote controller, and more particularly to a data transmission method for a remote controller, wherein a key on a remote controller is pressed once to simultaneously supply at least two data for a consecutive multistage operation to a predetermined apparatus controllable by the remote controller.

In electronic products or household electronic appliances a remote controller is widely used for controlling the operation of a specific appliance over a long distance. Such a remote controller transmits an operational signal either by radio transmission or an infrared ray is utilized as a transmission signal.

The remote controller is equipped with a plurality of keys for controlling predetermined operations, and the user's manipulation of a key on the remote controller supplies only one kind of data corresponding to the key pressed, thereby initiating a specific function of one appliance. U.S. Patent No. 4,866,434 describes the efficient storage of data in the memory of a remote control hand unit.

In the current trend to functional
improvement of the remote controller, a plurality of appliances are controlled by a single remote controller. A technique used in such a remote controller is disclosed in U.S. Patent No. 5,128,667. It provides a remote controller which is capable of controlling a plurality of appliances equipped as a set.

Furthermore, EP-A-0 392 872 describes addressing of several independent units by pointing the remote controller in the direction of the device, which should be controlled.

However, the conventional remote controller requires at least two key manipulations to consecutively operate more than two appliances. More specifically, when a video cassette recorder (VCR) and a television are equipped as one set, in order to use the VCR, the user must turn on the power of the VCR, and then set the channel of the television to three or four by means of a channel adjustment key or to a video mode. Accordingly, the key of the remote controller is manipulated at least twice such that the keys are pressed in the order of a power key and then channel key 3, or the power key and then video/TV mode conversion key.

Also, in a remote controller generally used with a VCR, which can operate a television, the user turns on the power of the VCR to select the television function of the remote controller and sets the channel number by means of the channel key. Thus, the user manipulates the keys at least three times according to this order. As described above, the conventional remote controller is inconvenient because it requires more than two key manipulations.

The present invention has been contrived to solve the above-described problems and it is the object of the present invention to provide a data transmission method for an improved remote controller for controlling different apparatuses of distinct types equipped as a set.

The above object is solved by the subject-matter of independent claim 1. Preferred embodiments are the subject-matter of the dependent claims.

The above object and other advantages of the present invention will become more apparent by describing in detail preferred embodiments thereof with reference to the attached drawings in which:
FIG. 1 is a circuit diagram showing a remote controller used for the present invention;
FIG. 2 is a flow chart showing one embodiment of a data transmission method of the remote controller according to the present invention;
FIG. 3 shows data supplied from the remote controller according to the present invention; and
FIGS. 4A to 4E show the formats of the first and second data illustrated in FIG. 3.

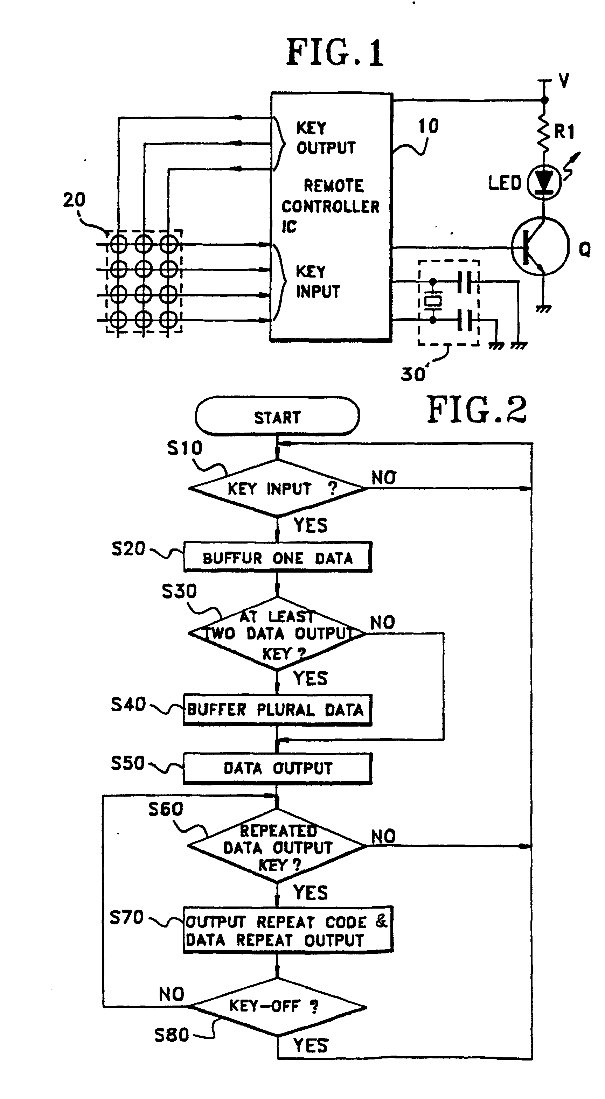

Referring to FIG. 1 showing a circuit diagram of a remote controller used for the present invention, a key matrix 20 capable of executing a key selection is connected to one side of a remote controller IC 10 for controlling the data transmission process of the remote controller. Another input of the remote controller IC 10 is connected to a crystal oscillator 30 which supplies a clock signal for the operation of the remote controller IC 10. A transistor Q for a switching operation in accordance with a signal from the remote controller IC 10, a light-emitting diode LED serially connected to the collector of the. transistor Q and a voltage supply resistor R1 are serially connected to another input of the remote controller IC 10. The resistor R1, light-emitting diode LED and the collector-base of the transistor Q form a closed loop together with the remote controller IC 10.

FIG. 2 is a flow chart showing the data transmission method of the remote controller according to the present invention. In order to carry out the method, the key matrix 20 of FIG. 1 is provided with an optional key for externally supplying consecutive data. Also, in the remote controller IC 10, an operation that consecutively outputs data upon pressing a key for supplying a plurality of data is preset while manufacturing the remote controller IC 10.

Here, the remote controller IC 10 performs step S10 of scanning to determine whether a key input by a user pressing a key of the remote controller exists or not, and performs step S20 for buffering a corresponding data in accordance with the key input to an unshown buffer within the remote controller when the key input exists. After performing step S20, the remote controller IC 10 determines in step S30 whether the key manipulated by the user is the key for supplying more than two data to execute the consecutive operation or not, and performs step S40 when the key is for supplying more than two data, thereby buffering the plurality of data corresponding to the key in the buffer of the remote controller IC 10. When the key pressed by the user is determined as a key which does not supply at least two data in step 30, or after the plurality of data are buffered in step S40, the remote controller IC 10 supplies the buffered data in step S20 or S40. Then, by determining whether the key received in step S10 is a key for setting a repeated output to prevent an error during the data transmission or not in step S60, the remote controller IC 10 executes step S70 to supply a repeat code and repeatedly supplies the data when the key is for setting the repeated output, and then the key on/off state is checked in step S80. If it is determined that the key is not turned off, step S60 is performed again.

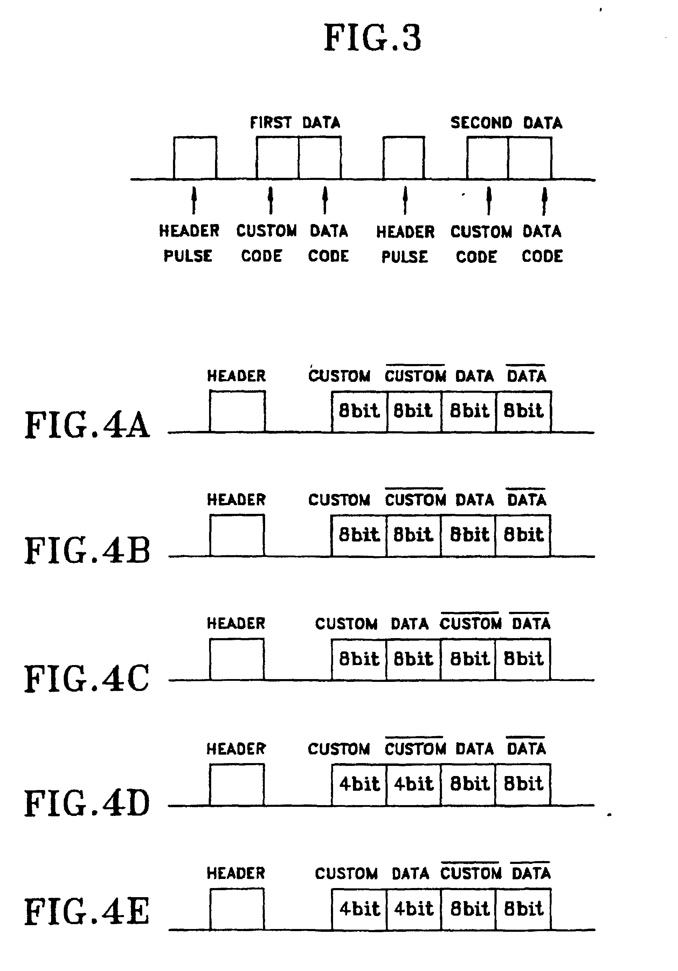

FIG. 3 shows the transmitted data from the remote controller according to the present invention. Here, a header pulse triggers an interrupt state, which functions by deciding the priority of processing the transmitted data and setting the interrupt state when an unshown microcomputer in the apparatus for receiving the data supplied from the remote controller goes to an interrupt state by the user's manipulation of the remote controller while the microcomputer is being operated. Moreover, composite data respectively formed of a custom code and a data code is disposed between respective header pulse. The custom code is for classifying products per manufacturing company, and data code corresponds to the data for operating an actual receiver.

When the user manipulates the key, the remote controller IC 10 supplies first and second data in order of the key input as shown in FIG. 3. At this time, the consecutive data of FIG. 3 corresponds to the first data which will be supplied in accordance with the power-on key input for turning on a VCR and the second data which will be supplied to the channel key input for selecting a television channel. FIGS. 4A to 4E show the formats of the first and second data illustrated in FIG. 3.

When the VCR and television are equipped as one set, the data transmission method of the remote controller will be described with reference to FIGS, 1 to 4.

If the user intends to use the VCR and television equipped as one set, the user turns on the power of the VCR by means of the remote controller, and then selects a channel of the television. A data output process in accordance with the channel selection will be described by separating into two cases that the user presses a key for supplying only one data and presses a key for supplying the plurality of data.

First, when the user presses the key for supplying only one data, the remote controller IC 10 executes step S20 after determining that the key input exists in step S10 to buffer one output data corresponding to the key signal received into the buffer within the remote controller IC 10, and, in step S50, provides the data buffered in step S20 since the key received by the user in step S30 is a key for producing one data. At this time, the output of the data is carried out by switching of the transistor Q and light-emitting operation of the light-emitting diode LED.

Second, when the user presses the key for supplying the plurality of data, the remote controller IC 10 executes step S20 after determining that the key input exists in step S10 to buffer one output data corresponding to the key signal received into the buffer within the remote controller IC 10, and, in step S40, buffers the plurality of data confirmed as the key for providing at least two data output keys and preset in step S40 via step S30 to be supplied. Then, in step S50, the data is produced by the switching of the transistor Q and the light-emitting operation of the light-emitting diode LED.

After carrying out step S50, the remote controller IC 10 checks whether the key received in step S10 is the key for the repeated output of data or not, to generate the repeat code in step S70 in case of the repeat output key, and then repeatedly provide the data. After step S70, the repeated output is continuously performed if the key remains in the pressed on state. When it is determined in step S80 that the key is not pressed to repeat output of data and the previously pressed key is in the off state, step S10 is carried out again.

The VCR and television controlled by the remote controller in accordance with the above-described process may be of the same or different manufacturing companies according to the user's intention. Therefore, the data for turning on the power of the VCR and the data for selecting the television channel may have the various formats as shown in FIG. 4.

Referring to FIGS, 4A to 4E, the data having the formats shown in FIG. 4 is supplied in accordance with the steps shown in FIG, 3. Here, if the key pressed by the user is for supplying one data, one data corresponding to the pressed key is produced. Similarly, if the key pressed by the user is for supplying the plurality of data, the consecutive plurality of data corresponding to the pressed key is produced. Respective data formats of the data are shown in FIG. 4. Assuming that FIG. 4A shows a data format for turning on the power of the VCR, the data format for selecting the television channel may be the same as shown in FIG. 4B in view of the number of bits and format; otherwise the arrangement of the custom code and data code are different but has the same number of bits as shown in FIG. 4C. Of course, as shown in FIG. 4D, the data format for the television-channel selection has the same format but a different number of bits; while the number of bits and format are different as shown in FIG. 4E.

Since the data format to be supplied from the remote controller can be easily adoptable by the designer in consideration of the apparatuses equipped as a set, various data formats of different cases as shown in FIG. 4 may be supplied from the remote controller.

In the above-described embodiment, turning on the power of the VCR and channel selection of the television are given as examples, but, with adopting the data transmission method of the remote controller according to the present invention, the user can consecutively carry out any desired operation which requires more than two keys of a conventional remote controller to be pressed, by pressing the key provided in accordance with the present invention only once.

According to the data transmission method for the remote controller of the present invention as described above, a key on the remote controller is pressed once to supply a plurality of data which execute the operations of a plurality of apparatuses equipped as a set, so that at least two operations can be performed by one key being pressed without requiring more than two keys to be pressed to successively carry out at least two operations.

## Claims

1. A data transmission method for a remote controller comprising a key matrix (20) with a plurality of keys, an integrated circuit (10) and a transmission means (R1, LED, Q) for transmitting a signal for controlling at least two different apparatuses of distinct types equipped as a set, said method comprising the steps of:
presetting a key for indicating a plurality of data outputs to said integrated circuit of said remote controller; and
consecutively producing said plurality of data comprising at least first and second data intended for transmission by said transmission means respectively to a first and second apparatus of said at least two different apparatuses of distinct types equipped as a set when a user presses said key to allow said apparatuses to successively carry out different operations in response to receipt of said plurality of data.

2. The method as claimed in claim 1, wherein said plurality of data have the same format but a different number of bits, respectively.

3. The method as claimed in claim 1, wherein said plurality of data have different formats but the same number of bits, respectively.

4. The method as claimed in claim 1, wherein said plurality of data have different formats and different number of bits, respectively.

## Patentansprüche

1. Datenübertragungsverfahren für eine Femsteuerung mit einer Tastenmatrix (20) mit mehreren Tasten, einer integrierten Schaltung (10) und einer Sendeeinrichtung (R1,LED,Q) zum Aussenden eines Signals zum Steuern wenigstens zweier unterschiedlicher Geräte bestimmter Arten, die als ein Satz angeordnet sind, wobei das Verfahren die Schritte umfaßt:
Voreinstellen einer Taste zum Angeben einer Mehrzahl von Datenausgaben an die integrierte Schaltung der Fernsteuerung; und
aufeinanderfolgendes Erzeugen der genannten Mehrzahl von Daten, die wenigstens erste und zweite Daten enthalten, die zur Aussendung von der Sendeeinrichtung jeweils zu einem ersten und zweiten Gerät der wenigstens zwei unterschiedlichen Geräte bestimmter Arten, die als ein Satz angeordnet sind, dienen sollen, wenn ein Benutzer die Taste drückt, um es den Geräten zu ermöglichen, aufeinanderfolgend unterschiedliche Vorgänge in Antwort auf den Empfang der Mehrzahl von Daten auszuführen.

2. Verfahren nach Anspruch 1, wobei die Mehrzahl von Daten dasselbe Format aber jeweils eine unterschiedliche Anzahl von Bits haben.

3. Verfahren nach Anspruch 1, wobei die Mehrzahl von Daten unterschiedliche Formate aber jeweils dieselbe Anzahl von Bits haben.

4. Verfahren nach Anspruch 1, wobei die Mehrzahl von Daten jeweils unterschiedliche Formate und eine unterschiedliche Anzahl von Bits haben.

## Revendications

1. Procédé de transmission de données pour une commande à distance comportant une matrice de touches (20) ayant une pluralité de touches, un circuit intégré (10) et des moyens de transmission (R1, LED, Q) pour transmettre un signal destiné à commander au moins deux dispositifs différents de types distincts équipés comme un poste, ledit procédé comportant les étapes consistant à :
prérégler une touche pour indiquer une pluralité de données émises vers ledit circuit intégré de ladite commande à distance, et
produire consécutivement ladite pluralité de données comportant au moins des premières et des secondes données destinées à être transmises par lesdits moyens de transmission respectivement vers un premier et un second dispositif desdits au moins deux dispositifs différents de types distincts équipés comme un poste lorsqu'un utilisateur appuie sur ladite touche pour permettre auxdits dispositifs d'exécuter successivement différentes opérations en réponse à la réception de ladite pluralité de données.

2. Procédé selon la revendication 1, dans lequel ladite pluralité de données a le même format mais un nombre différent de bits, respectivement.

3. Procédé selon la revendication 1, dans lequel ladite pluralité de données a différents formats mais le même nombre de bits, respectivement.

4. Procédé selon la revendication 1, dans lequel ladite pluralité de données a différents formats et différents nombres de bits, respectivement.
